# EUROPÄISCHE PATENTSCHRIFT

(11) **EP 0 931 339 B1**
(45) Veröffentlichungstag und Bekanntmachung des Hinweises auf die Patenterteilung: **12.03.2003**
(21) Anmeldenummer: 97942796.0
(22) Anmeldetag: 05.09.1997
(51) Int. Cl.: H01L 21/8242, H01L 27/108

(54) **VERFAHREN ZUR HERSTELLUNG EINES DRAM-KONDENSATORS MIT GESTAPELTEN ELEKTRODEN**
METHOD OF PRODUCTION OF A DRAM CAPACITOR WITH STACKED ELECTRODES
PROCEDE DE PRODUCTION D'UN CONDENSATEUR DE MEMOIRE RAM DYNAMIQUE A ELECTRODES EMPILEES

(30) Priorität: 30.09.1996 DE 19640271
(43) Veröffentlichungstag der Anmeldung: 28.07.1999
(73) Patentinhaber: Infineon Technologies AG, 81669 München (DE)
(72) Erfinder: SCHINDLER, Günther, D-80802 München (DE); HARTNER, Walter, D-89441 Medlingen (DE); MAZURE-ESPEJO, Carlos, D-85604 Zorneding (DE)
(74) Vertreter: Zimmermann & Partner
(86) Internationale Anmeldenummer: DE9701965
(87) Internationale Veröffentlichungsnummer: WO98015000

(56) Entgegenhaltungen:
- EP-A- 0 415 530
- EP-A- 0 657 935
- GB-A- 2 245 761
- PATENT ABSTRACTS OF JAPAN vol. 15, no. 383 (E-1116), 27.September 1991 & JP 03 153074 A (MITSUBISHI ELECTRIC CORP), 1.Juli 1991, in der Anmeldung erwähnt

## Beschreibung

Derartige Speicher sind beispielsweise aus Müller, "Bauelemente der Halbleiterelektronik", Springer, 4. Auflage, 1991, S. 256 ff. bekannt. Beschrieben ist hier eine Speicherzelle mit einem Speicherkondensator, dessen eine Elektrode nahezu als ebene Platte ausgebildet und parallel zu einer Hauptfläche der Speicheranordnung angeordnet ist. Um die Kapazität des Speicherkondensators, die bekanntlich von der Kondensatorfläche abhängt, mit zunehmender Integrationsdichte, und damit verbundener Verkleinerung der Speicheranordnung, möglichst nicht kleiner werden zu lassen, wird in o. g. Literatur eine Ausbildung des Speicherkondensators als Trench-Kondensator vorgeschlagen, der topfartig in einer Hauptfläche der Speicheranordnung angeordnet ist. Letztere Realisierungsmöglichkeit des Speicherkondensators weist gegenüber der erstgenannten einen erheblich größeren Realisierungsaufwand auf.

Eine weitere Möglichkeit zur Beibehaltung einer bestimmten Kondensatorfläche bei zunehmender Integrationsdichte ist in US 5,290,726 gezeigt. Beschrieben ist hier eine Realisierung des Speicherkondensators als Fin-Stacked-Kondensator, der über dem Auswahltransistor der Speicherzelle angeordnet ist. Eine erste Elektrode des Speicherkondensators besitzt bei dieser Realisierungsform einen Querschnitt, der mehrere nebeneinander und übereinander liegende Finger aufweist, um die Elektrodenoberfläche und damit die Kondensatorfläche gegenüber einer plattenartigen Ausbildung der ersten Elektrode zu erhöhen. Eine derartige Realisierung des Speicherkondensators setzt eine gewisse Mindestfläche über dem Auswahltransistor voraus, innerhalb der der Kondensator realisiert werden kann. Mit zunehmender Integrationsdichte ist es schwierig, diese zur Realisierung des Kondensators notwendige Mindestfläche zur Verfügung zu stellen. Ferner ist die beschriebene Kondensatorstruktur sehr aufwendig im Herstellungsverfahren.

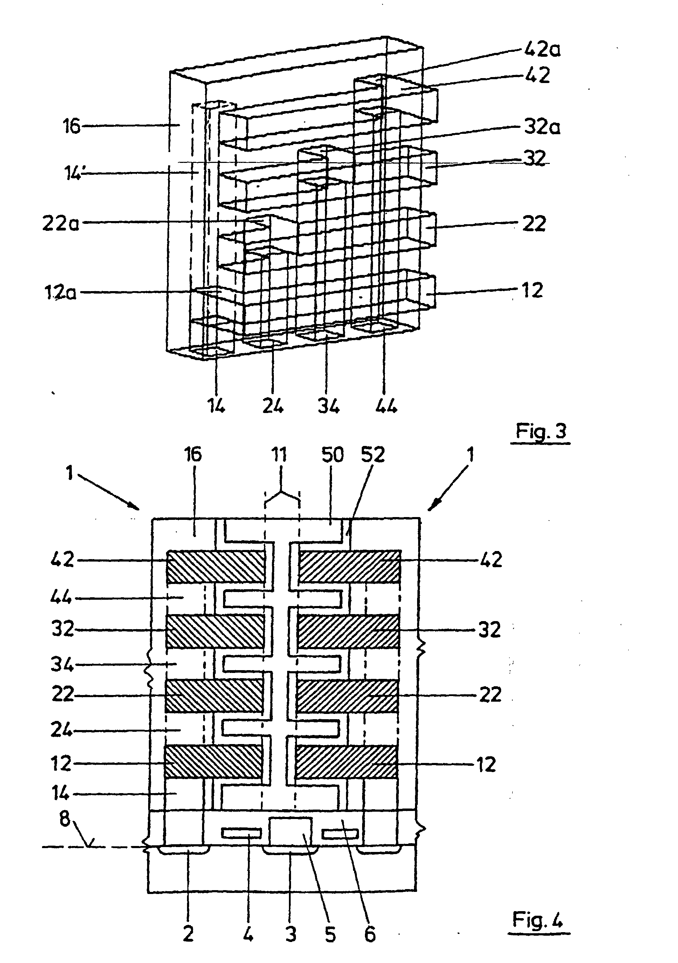

Aus EP 06 57 935 A2 ist ebenfalls bereits eine Halbleiterspeicheranordnung und ein Verfahren zum Herstellen einer solchen Halbleiterspeicheranordnung bekannt. Die Speicheranordnung zeichnet sich durch Speicherkondensatoren aus, bei denen die ersten Elektroden als Elektrodenplatten ausgebildet und beabstandet übereinander sowie paralell zu einer oberen Hauptfläche der Halbleiterspeicheranordnung angeordnet sind. Diese Elektrodenplatten sind jeweils durch Kontaktplugs mit Auswahltransistoren einer Speicherzelle elektrisch verbunden. Gemäß dortiger Figur 3B sind die einzelnen Kontaktplugs entsprechend dem Abstand zur jeweiligen Elektrodenplatte unterschiedlich lang ausgebildet.

In JP 03-153074 A und JP 62-179759 A sind ebenfalls Halbleiterspeicheranordnungen mit Speicherkondensatoren, die plattenförmige Elektroden aufweisen, beschrieben.

In GB 2 245 761 ist ebenfalls eine Halbleiterspeicheranordnung mit Speicherkondensatoren beschrieben, wobei die Speicherkondensatoren Speicherelektroden aufweisen, die aus mehreren Polysilziumschichten bestehen. Dabei sind die Polysilziumschichten eines Speicherkondensator jeweils zwischen den Polysilziumschichten der benachbarten Speicherkondensatoren angeordnet.

Die Erfindung hat das Ziel, ein Verfahren zur Herstellung einer integrierten Halbleiterspeicheranordnung anzugeben, die trotz zunehmender Integrationsdichte eine ausreichend große Kondensatorfläche bzw. eine ausreichend große Kapazität in einfacher Weise zur Verfügung stellt.

Dieses Ziel wird druch die im Anspruch 1 angegebenen Merkmale gelöst.

Weiterbildungen des Herstellverfahrens nach der Erfindung sind in den auf den Anspruch 1 zurückbezogenen Unteransprüchen angegeben.

Das Verfahren zur Herstellung einer integrierten Halbleiterspeicheranordnung nach der Erfindung weist demnach folgende Verfahrensschritte auf:
a) Bereitstellen eines Halbleiterkörpers mit Auswahltransitoren für Speicherzellen einer Speicheranordnung sowie mit auf der Hauptfläche des Halbleiterkörpers angeordneten, zugänglichen Kontakten, die mit jeweils einem Auswahltransistor einer Speicherzelle elektrisch verbunden sind;
b) Abscheidung mehrerer übereinanderliegender und abwechselnder Schichten von Elektrodenplatten und Isoliermaterial, wobei jede der Elektrodenplatten eine in Richtung seines zugehörenden Kontaktes vorspringende Nase aufweist;
c) Ätzen von Löchern über den jeweiligen Kontakten bis zur Hauptfläche und Auffüllen dieser Löcher mit leitfähigem Material, so daß Kontaktplugs erzeugt werden, wobei die Elektrodenplatten an ihren vorspringenden Nasen von dem leitfähigem Material kontaktiert werden;
d) Abscheidung einer Isolierschicht auf den oberen Enden der Kontaktplugs;
e) Ätzen eines zur Hauptfläche des Halbleiterkörpers angeordneten Grabens durch sämtliche Schichten aus Elektrodenmaterial und Isoliermaterial;
f) Isotrope Ätzung des Isoliermaterials zwischen den Schichten aus Elektrodenmaterial derart, dass die Kontaktplugs von der Isolierschicht umgeben bleiben und die Schichten aus Elektrodenmaterial in Form von Elektrodenplatten in den Graben hineinragen;
g) Konformes Abscheiden einer Dielektrikumsschicht auf die Elektrodenplatten;
h) Auffüllen des Grabens mit mindestens einem elektrisch leitfähigem Material zur Bildung einer weiteren Elektrode (50) für die Speicherkondensatoren.

Bei diesem Herstellverfahren werden zunächst sämtliche Elektroden- und Isolierschichten abgeschieden und anschließend die Löcher für die Kontaktplugs über den jeweiligen Kontakten geätzt und mit leitfähigem Material aufgefüllt. Hierbei wären alle Kontaktplugs gleich lang und würden seitlich mit hervorspringenden Nasen der Elektrodenplatten elektrisch in Verbindung stehen, wobei aufgrund von versetzt zueinander angeordneten Nasen an den verschiedenen übereinanderliegenden Elektrodenplatten wieder nur jeweils ein Kontaktplug eine Elektrodenplatte kontaktiert. Um einen Kurzschluß mit der Gegenelektrode, also zweiten Elektrode, der Speicherkondensatoren zu vermeiden, muß auf die oberen Enden der Kontaktplugs noch eine Isolierschicht abgeschieden werden, um die Enden der Kontaktplugs zu überdecken.

Dieses Herstellverfahren hat den Vorteil, daß die Kontaktlochätzung nur ein einziges Mal gemeinsam für alle Kontaktplugs nötig ist, was eine Prozeßvereinfachung bedeutet.

In einer Weiterbildung des Verfahrens kann als Dielektrikumsschicht ein hoch-ε-Material oder ein ferroelektrisches Material verwendet werden. In diesem Fall müssen die Elektroden zumindest auf ihrer dem Dielektrikum zugewandten Seiten ein Edelmetall aufweisen, z.B. Pt, Ru, Ir, Pd, oder Oxide wie z.B. IrO₂, RuO_{2,} LaSrCoOₓ oder dgl., oder vollständig aus diesen Materialien bestehen. Für die Gegenelektrode bietet es sich an, zunächst eines dieser genannten Materialien konform als dünne Schicht über dem Dielektrikum abzuscheiden und den verbleibenden Graben mit einem weiteren elektrisch leitenden Material, z.B. Polysilizium aufzufüllen.

Bei der so hergestellten integrierten Halbleiteranordnung sind die ersten Elektroden einer Gruppe von Speicherzellen jeweils als Elektrodenplatten ausgebildet und liegen beabstandet übereinander sowie parallel zu einer Hauptfläche der Halbleiterspeicheranordnung. Des weiteren ist jede dieser ersten Elektrodenplatten durch einen Kontaktplug mit dem Auswahltransistor einer Speicherzelle der Gruppe elektrisch verbunden, wobei die einzelnen Kontaktplugs einer Gruppe von Speicherzellen entsprechend des Abstandes zur jeweiligen Elektrodenplatte unterschiedlich lang ausgebildet sind.

Die Elektrodenplatten sind folglich sandwichartig übereinander beabstandet angeordnet, wobei jede dieser Elektrodenplatten separat über einen Kontaktplug mit dem Auswahltransistor einer Speicherzelle elektrisch verbunden ist. Die sandwichartige Anordnung der Elektrodenplatten erlaubt es in sehr einfacher Weise, daß die Elektrodenplatten auch Zellflächen benachbarter Speicherzellen auf dem Halbleiterkörper überragen können, so daß die geforderte große Elektrodenfläche und damit erhöhte Kapazität der Speicherkondensatoren erreicht wird.

Die Kontaktplugs stehen hierbei zweckmäßigerweise jeweils mit einem Source-Gebiet eines Auswahltransistors einer Speicherzelle elektrisch in Kontakt, wobei sich die Kontaktplugs im wesentlichen orthogonal zu den Plattenebenen der Elektrodenplatten erstrecken.

Wenngleich es im Rahmen vorliegender Erfindung bereits ausreicht, daß sich die Elektrodenplatte in eine einzige Zellfläche einer benachbarten Speicherzelle hinein erstreckt, bietet es sich zur Erhöhung der Kapazität der Speicherkondensatoren an, die Elektrodenplatten so groß zu wählen, daß diese in mehrere Zellflächen ragen.

Des weiteren ist es vorgesehen, daß eine Gruppe von Speicherzellen jeweils n übereinander oder nebeneinander angeordnete Speicherzellen aufweist, welche über jeweils einen von n Kontaktplugs mit n übereinanderliegenden Elektrodenplatten elektrisch in Kontakt stehen und n eine natürliche Zahl größer 2, z.B. n = 4, ist. Da es sich bei der Anzahl der Speicherzellen in einem Speicherarray einer integrierten Halbleiterspeicheranordnung regelmäßig um eine Potenz von 2 handelt, ist zweckmäßigerweise n = 2^{m} zu wählen, wobei m eine natürliche ganze Zahl ist, also 1, 2, 3, 4, usw..

Des weiteren sind erfindungsgemäß die Kontaktplugs von einer Isolierschicht umgeben, aus der sich die Elektrodenplatten gemeinsam in einer Richtung heraus erstrecken.

Eine andere Ausführungsform der nach der Erfindung hergestellten Speicheranordnung sieht vor, daß die übereinanderliegenden Elektrodenplatten der jeweils ersten Elektroden einer Gruppe von Speicherzellen jeweils übereinanderliegenden Elektrodenplatten der jeweils ersten Elektroden einer anderen Gruppe von Speicherzellen mit einem vorgegebenen Abstand zugewandt angeordnet sind. Hierbei kann zwischen den gegenüberliegenden ersten Elektroden der beiden Gruppen von Speicherzellen eine als zweite Elektrode dienende Gegenelektrode angeordnet werden, wobei zwischen der Gegenelektrode und den die jeweils erste Elektrode einer Speicherzelle bildenden Elektrodenplatten die Dielektrikumsschicht angeordnet ist.

Der wesentliche Vorteil der so hergestellten integrierten Halbleiterspeicheranordnung nach der Erfindung ist darin zusehen, daß der Speicherkondensator nicht auf die Grundfläche einer Speicherzelle beschränkt ist. Die Speicherkondensatoren werden vielmehr für mehrere Speicherzellen zusammengefaßt und übereinander angeordnet. Bei n zusammengefaßten Speicherzellen steht so für jeden Speicherkondensator sowie dessen elektrischen Zuleitung eine Grundfläche von n * Zellfläche zur Verfügung.

Die Erfindung wird nachfolgend im Zusammenhang eines Ausführungsbeispieles anhand von Figuren näher erläutert. Es zeigen:
- Fig. 1: ein Layout für eine integrierte Halbleiterspeicheranordnung mit einem Speicherarray, bei welchem Elektrodenplatten von Speicherkondensatoren einer Speicherzelle in benachbarte Speicherzellflächen ragen,
- Fig. 2: verschiedene schematische Schnittansichten durch eine integrierte Halbleiterspeicheranordnung auf Höhe der oberen Hauptfläche des Halbleiterkörpers mit den integrierten Auswahltransistoren und auf Höhe der einzelnen, übereinander angeordneten Elektrodenplatten,
- Fig. 3: eine schematische dreidimensionale Darstellung der Anordnung von Elektrodenplatten und Kontaktplugs für mehrere Speicherzellen nach Fig. 1, und
- Fig. 4: ein Schnittansicht durch die Speicherkondensatoren bei einer nach der Erfindung aufgebauten, integrierten Halbleiterspeicheranordnung.

In den nachfolgenden Figuren bezeichnen, sofern nicht anders angegeben, gleiche Bezugszeichen gleiche Teile mit gleicher Bedeutung.

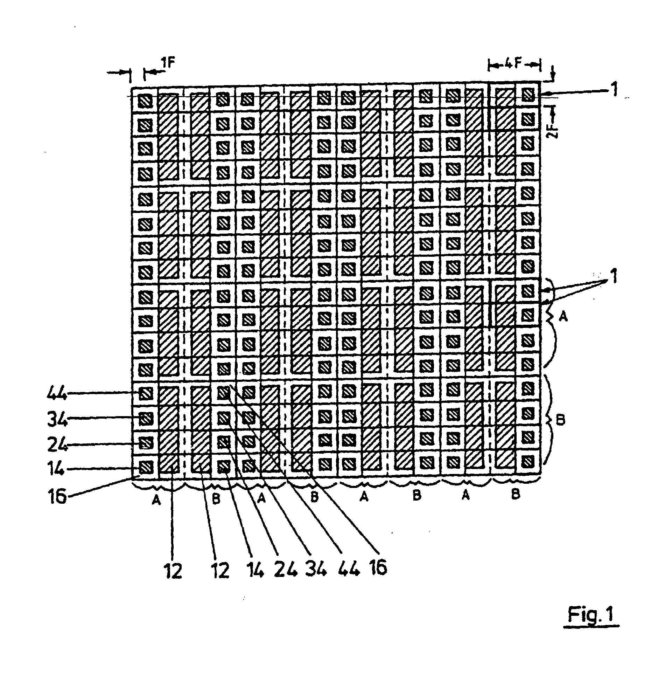

In Fig. 1 ist ein, Ausführungsbeispiel einer nach dem erfindungsgemäßen Herstellverfahren, produzierten integrierten Halbleiterspeicheranordnung dargestellt. Die Fig. 1 zeigt die Draufsicht auf ein Speicherarray mit einer Vielzahl, hier 128, von ähnlich aufgebauten Speicherzellen 1. Jede Speicherzelle 1 hat bei dem dargestellten Speicherarray eine Zellfläche mit einer Breite von 4F und einer Zellhöhe von 2F, so daß die Zellfläche einer einzigen Speicherzelle insgesamt 8F² beträgt. Wie dargestellt, sind die einzelnen Speicherzellen in Gruppen A, B zu jeweils vier Speicherzellen 1 zusammengefaßt, wobei das dargestellte Speicherarray insgesamt 16 identische Gruppenpaare mit Gruppen A und B aufweist. (Anmerkung: F bezeichnet den sogenannten "feature size". Dies ist die Breite der kleinsten herstellbaren Struktur bei integrierten Schaltkreisen. F ist von der benutzten Technologie abhängig und meist durch die Auflösung der Photolithografie bestimmt. F ist also eine für die verwendete Herstelltechnologie von integrierten Schaltkreisen charakteristische Längeneinheit.) Bei dem dargestellten Ausführungsbeispiel von Fig. 1 sind in den Speicherzellen 1 der Gruppe A jeweils in der linken Hälfte der Zellfläche noch zu erläuternde Kontaktplugs 14, 24, 34 und 44 und in den Speicherzellen 1 jeder Gruppe B jeweils in der rechten Hälfte der Zellfläche Kontaktplugs 14, 24, 34 und 44 angeordnet. Diese Kontaktplugs 14, 24, 34, 44 erstrecken sich aus der Hauptfläche des Halbleiterkörpers der integrierten Speicheranordnung in Richtung Betrachter von Fig. 1 und dienen dazu, jeweils eine Elektrodenplatte, die eine erste Elektrode eines Speicherkondensators einer Speicherzelle bildet, zu kontaktieren. Die Kontaktplugs 14, 24, 34 und 44 sind, bis auf die elektrischen Anschluß an jeweils eine Elektrodenplatte, von einer Isolierschicht 16 umgeben. Wie die schematische Ansicht von Fig. 1 zeigt, nimmt die Isolierschicht 16 jeweils von oben her gesehen diejenige Hälfte der Zellfläche einer Speicherzelle ein, welche bereits mit einem Kontaktplug 14, 24, 34 und 44 besetzt ist.

In Fig. 1 sind erste Elektrodenplatten 12 dargestellt, die z.B. mit den Kontaktplugs 14 jeder der Gruppen von Speicherzellen 1 elektrisch in Verbindung stehen. Jede dieser Elektrodenplatten 12 erstreckt sich in die noch freien Hälften der Zellflächen derjenigen Speicherzellen 1, die zu einer Gruppe A bzw. B gehören. Allerdings ragen die Elektrodenplatten 12 nicht ganz bis zum äußeren Rand der benachbarten Zellflächen. Hierdurch verbleibt, wiederum von oben her auf das Speicherarray gesehen, ein Spalt 9 zwischen den einzelnen Elektrodenplatten 12 der Gruppen A, B von Speicherzellen 1 bestehen, der für das Zwischenfügen einer Dielektrikumsschicht und einer Gegenelektrode erforderlich ist, wie im Zusammenhang mit Fig. 4 noch erläutert werden wird.

Die Elektrodenplatten 12 haben im Ausführungsbeispiel von Fig. 1 eine Fläche von 31F², wenn angenommen wird, daß die Elektrodenplatte eine Dicke von jeweils 1F aufweist. Dieser Wert kann selbstverständlich erhöht werden, wenn noch mehr Speicherzellen 1 zu einer Gruppe A bzw. B zusammengefaßt werden und sich die Elektrodenplatten 12 in entsprechend mehr Zellflächen anderer Speicherzellen 1 erstrecken. Dies erfordert dann jedoch auch entsprechend mehr übereinanderliegende Elektrodenplatten.

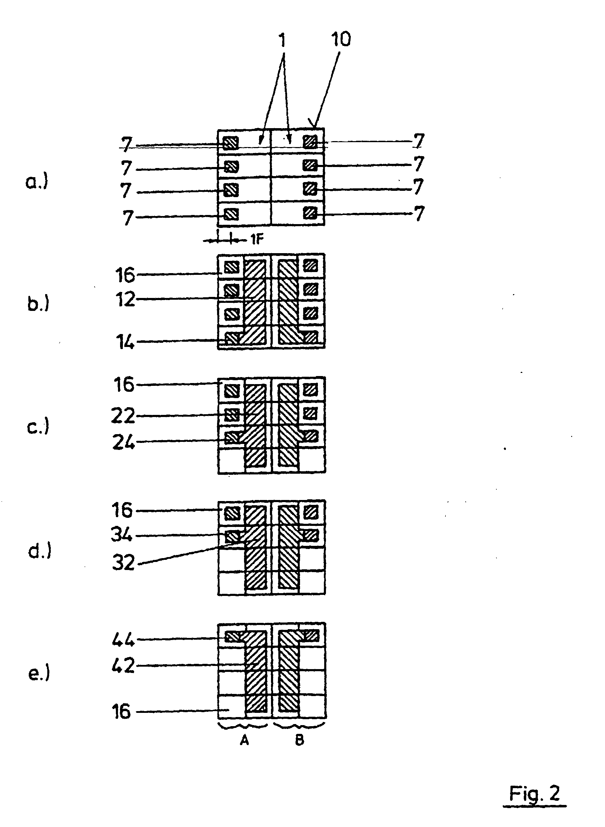

In Fig. 2 sind zum besseren Verständnis fünf verschiedene Schnittansichten a, b, c, d und e des Speicherarrays von Fig. 1 dargestellt. Die einzelnen Schnitte sind parallel zur Hauptfläche der Speicheranordnung für zwei gegenüberliegende Gruppen A bzw. B von Speicherzellen 1 genommen. Die rechteckförmige Zellfläche ist mit 10 bezeichnet. In Fig. 2a ist der Schnitt auf Höhe von Kontakten 7 genommen, die an der oberen Hauptfläche eines Halbleiterkörpers, in welchem Auswahltransistoren eingebettet sind, sitzen. Die Kontakte 7 stehen jeweils mit einem Source-Gebiet eines solchen Auswahltransistors elektrisch in Verbindung.

Fig. 2b zeigt eine Schnittansicht auf Höhe einer ersten Elektrodenplatte 12, wie diese bereits in Fig. 1 erklärt wurde. Allerdings zeigt Fig. 2b jetzt sehr deutlich, die elektrische Verbindung der Kontaktplugs 14 mit den Elektrodenplatten 12, welche hierfür L-förmig ausgebildet sind. Die übrigen Kontaktplugs 24, 34 und 44 sind ebenfalls erkennbar, da diese länger als die Kontaktplugs 14 ausgebildet sind. Das Bezugszeichen 16 steht wieder für die die Kontaktplugs 14, 24, 34 und 44 umgebende Isolierschicht.

In den Fig. 2c, 2d und 2e sind die Schnittansichten auf Höhe der Elektrodenplatten 22, 32 und 42 dargestellt. Die Elektrodenplatten 22 und 32 springen ebenfalls nasenartig in Richtung der jeweiligen Kontaktplugs 24, 34 und 44 hervor und sind mit diesen elektrisch in Kontakt. Die einzelnen Schnittansichten lassen deutlich erkennen, daß der Kontaktplug 16 am längsten ist, um die von den Kontakten am weitesten beabstandete Elektrodenplatte 42 zu kontaktieren. Die Kontaktplugs 14, 24, 34 und 44 verbinden jeden der Kontakte 7 von Fig. 2a genau mit einer der Elektrodenplatten 12, 22, 32 und 42.

In Fig. 3 ist eine schematische dreidimensionale Darstellung der Anordnung von Kontaktplugs 14, 24, 34 und 44, Isolierschicht 16 und Elektrodenplatten 12, 22, 32 und 42 dargestellt. Wie ersichtlich, ragen die Elektrodenplatten 12, 22, 32 und 42 parallel zueinander ausgerichtet und beabstandet zueinander aus der Isolierschicht 16 heraus. Die Kontaktplugs 14, 24, 34 und 44 sind in die Isolierschicht 16 eingebettet, ebenso wie die "Kontaktzungen" bzw. nasenförmigen Fortsätze 12a, 22a, 32a, 42a der Elektrodenplatten 12, 22, 32 und 42.

Bei dem erfindungsgemäßen Herstellverfahren einer Halbleiterspeicheranordnung werden zunächst sämtliche Elektroden- und Isolierschichten abgeschieden und anschließend die Löcher für die Kontaktplugs über den jeweiligen Kontakten geätzt und mit leitfähigem Material aufgefüllt werden. Hierbei sind dann alle Kontaktplugs gleich lang. Dies ist in Fig. 3 lediglich für den Kontaktplug 14' dargestellt, welcher strichliert gezeichnet ist. Dieser Kontaktplug 14' wird ausschließlich von der Kontaktzunge bzw. dem nasenförmigen Fortsatz 12a der Elektrodenplatte 12 kontaktiert.

Fig. 4 zeigt eine Schnittansicht durch einen Teil der integrierten Halbleiterspeicheranordnung nach der Erfindung, wobei der Schnitt orthogonal zu den Plattenebenen der Elektrodenplatten 12, 22, 32 und 42 genommen ist. Wie ersichtlich, stehen sich paarweise die Elektrodenplatten 12, 22, 32 und 42 der Gruppen A und B von Speicherzellen 1 mit ihren Stirnseiten beabstandet gegenüber. Die freien Flächen der Elektrodenplatten 12, 22, 32 und 42 sind gleichmäßig von einer Dielektrikumsschicht 52 umgeben, die im Schnitt gesehen, mäanderförmig die Elektrodenplatten 12, 22, 32 und 42 umgibt. Der verbleibenden Zwischenraum ist mit einer elektrisch leitenden Schicht aufgefüllt, die als Gegenelektrode und damit als zweite Elektrode für die Speicherzellen dient. Diese Gegenelektrode 50 ist z.B. mit Bezugspotential der integrierten Halbleiterspeicheranordnung verbunden.

Bei der Darstellung von Fig. 4 sind die Kontaktplugs 14, 24, 34 und 44 hintereinander angeordnet. Es ist lediglich der kürzeste Kontaktplug 14 im Schnitt erkennbar. Dieser Kontaktplug 14 kontaktiert, wie auch die anderen Kontaktplugs 24, 34 und 44 das Source-Gebiet 2 eines Auswahltransistors. Neben dem Source-Gebiet 2 befindet sich ein Drain-Gebiet 3, das mit einer Bitleitung 5 elektrisch in Kontakt ist. Zwischen dem Drain-Gebiet 3 und Source-Gebiet 2 liegt ein nicht dargestelltes Gate-Gebiet sowie eine Wortleitung 4, die für eine integrierte Speicherzelle notwendig sind.

Die Struktur des integrierten Speicherkondensators gemäß Fig. 4 kann mit folgenden Verfahrensschritten hergestellt werden. Oberhalb der letzten Verdrahtungsebene einer integrierten Halbleiterspeicheranordnung werden mehrere Schichten Elektrodenmaterial, z.B. Metall oder ein stark dotiertes Halbleitermaterial, wie Silizium oder Galliumarsenid, und ein Isoliermaterial abgeschieden. Die einzelnen Schichten sind vorzugsweise äguidistant zueinander beabstandet. Zusätzlich werden Löcher für die elektrische Verbindungen über den jeweiligen Kontakten 7 geätzt und anschließend mit elektrisch leitfähigem Material zur Bildung der Kontaktplugs 14, 24, 34, und 44 aufgefüllt. Anschließend wird ein senkrechter Graben (vgl. in Fig. 4 die strichlierte Grabenlinie 11) durch alle Elektrodenplatten 12, 22, 32 und 42 geätzt. Eine isotrope Ätzung des Isoliermaterials 16 sorgt dafür, daß das Elektrodenmaterial der Elektrodenplatten 12, 22, 32 und 42 in Form dünner Platten in den Graben hineinragt. Anschließend wird ein Dielektrikum zur Bildung der Dielektrikumsschicht 52 konform auf die Elektrodenplatten 12, 22, 32 und 42 aufgetragen. Hierfür ist. z.B. ein CVD-Prozeß geeignet. In einem weiteren Schritt wird der Graben mit leitfähigem Material zur Bildung der Gegenelektrode 50 aufgefüllt.

## Patentansprüche

1. Verfahren zur Herstellung einer integrierten Halbleiterspeicheranordnung mit Speicherkondensatoren mit folgenden Verfahrensschritten:
a) Bereitstellen eines Halbleiterkörpers mit Auswahltransitoren für Speicherzellen (1) einer Speicheranordnung sowie mit auf der Hauptfläche (8) des Halbleiterkörpers angeordneten, zugänglichen Kontakten (7), die mit jeweils einem Auswahltransistor einer Speicherzelle (1) elektrisch verbunden sind;
b) Abscheidung mehrerer übereinanderliegender und abwechselnder Schichten von Elektrodenplatten (12, 22, 32, 42) **und Isoliermaterial (16),** wobei jede der Elektrodenplatten (12, 22, 32, 42) eine in Richtung seines zugehörenden Kontaktes (7) vorspringende Nase (12a, 22a, 32, 42a) aufweist;
c) Ätzen von Löchern über den jeweiligen Kontakten (7) bis zur Hauptfläche (8) und Auffüllen dieser Löcher mit leitfähigem Material, **so daß Kontaktplugs (14, 24, 34, 44) erzeugt werden,** wobei jeder Kontaktplug sich bis zur entsprechenden, vorsprigenden Nase erstreckt, so daß die Elektrodenplatten (12, 22, 32, 42) an ihren vorspringenden Nasen (12a, 22a, 32a, 42a) von dem leitfähigem Material kontaktiert werden;
d) Abscheidung einer Isolierschicht auf den oberen Enden der Kontaktplugs (14, 24, 34, 44);
e) Ätzen eines zur Hauptfläche (8) des Halbleiterkörpers angeordneten Grabens (11) durch sämtliche Schichten aus Elektrodenmaterial und Isoliermaterial (16);
f) Isotrope Ätzung des Isoliermaterials (16) zwischen den Schichten aus Elektrodenmaterial derart, dass die Kontaktplugs (14, 24, 34, 44) von der Isolierschicht (16) umgeben bleiben und die Schichten aus Elektrodenmaterial in Form von Elektrodenplatten (12, 22, 32, 42) in den Graben hineinragen;
g) Konformes Abscheiden einer Dielektrikumsschicht (52) auf die Elektrodenplatten (12, 22, 32, 42);
h) Auffüllen des Grabens mit mindestens einem elektrisch leitfähigem Material zur Bildung einer weiteren Elektrode (50) für die Speicherkondensatoren.

2. Verfahren nach Anspruch 1, dadurch gekennzeichent, daß als Dielektrikumsschicht (52) ein hoch-ε-Material oder ein ferroelektrisches Material verwendet wird, und daß die Elektrodenplatten (12, 22, 32, 42) zumindest auf ihrer der Dielektrikumsschicht (52) zugewandten Seiten ein Edelmetall oder Oxide aufweisen oder vollständig aus diesen Materialien bestehen.

3. Verfahren nach Anspruch 2, **dadurch gekennzeichnet, daß** zur Bildung der zweiten Elektrode (50) zunächst eines der genannten Materialien konform als dünne Schicht über der Dielektrikumsschicht (52) abgeschieden und ein verbleibender Graben mit einem weiteren elektrisch leitenden Material aufgefüllt wird.

## Claims

1. Method for the production of an integrated semiconductor memory arrangement having following method steps:
a) provision of a semiconductor body with selection transistors for memory cells (1) of a memory arrangement as well as with accessible contacts (7) which are arranged on the main area (8) of the semiconductor body and are electrically connected to a respective selection transistor of a memory cell (1);
b) deposition of a plurality of alternate layers - lying one above the other - of electrode plates (12, 22, 32, 42) and insulating material (16), each of the electrode plates (12, 22, 32, 42) having a lug (12a, 22a, 32, 42a) protruding in the direction of its associated contact (7);
c) etching of holes above the respective contacts (7) as far as the main area (8) and filling of these holes with conductive material, thereby producing contact plugs (14, 24, 34, 44), each contact plug extending as far as the corresponding protruding lug, so that the electrode plates (12, 22, 32, 42) are contact-connected by the conductive material at their protruding lugs (12a, 22a, 32a, 42a);
d) deposition of an insulating layer on the upper ends of the contact plugs (14, 24, 34, 44);
e) etching of a trench (11), which is arranged [lacuna] to the main area (8) of the semiconductor body, through all the layers of electrode material and insulating material;
f) isotropic etching of the insulating material (16) between the layers of electrode material in such a way that the contact plugs (14, 24, 34, 44) remain surrounded by the insulating layer (16) and the layers of the electrode material project into the trench in the form of electrode plates (12, 22, 32, 42);
g) conformal deposition of a dielectric layer (52) on the electrode plates (12, 22, 32, 42);
h) filling of the trench with at least one electrically conductive material in order to form a further electrode (50) for the storage capacitors.

2. Method according to Claim 1, **characterized in that** a high-ε material or a ferroelectric material is used as the dielectric layer (52), and **in that** the electrode plates (12, 22, 32, 42), at least on their sides facing the dielectric layer (52), have a noble metal or oxides or are composed completely of these materials.

3. Method according to Claim 2, **characterized in that**, in order to form the second electrode (50), firstly one of the abovementioned materials is deposited conformally as a thin layer over the dielectric layer (52) and a remaining trench is filled with a further, electrically conductive material.

## Revendications

1. Procédé de production d'un dispositif de mémoire intégrée à semi-conducteur comprenant des condensateurs de mémoire ayant les stades de procédé suivants :
a) on met à disposition un corps semiconducteur ayant des transistors de sélection pour des cellules (1) de mémoire d'un dispositif de mémoire, ainsi que des contacts (7) qui sont disposés sur la surface (8) principale du corps semiconducteur, qui sont accessibles et qui sont reliés électriquement respectivement à un transistor de sélection d'une cellule (1) de mémoire ;
b) on dépose plusieurs couches superposées et alternées de plaques (12, 22, 32, 42) d'électrode et de matière (16) isolante, chacune des plaques (12, 22, 32, 42) d'électrode ayant un bec (12a, 22a, 32a, 42a) en saillie dans la direction de son contact (7) associé ;
c) on ménage par attaque des trous au dessus des contacts (7) respectif jusqu'à la surface (8) principale et on emplit ces trous de matière conductrice de manière à produire des tampons (14, 24, 34, 44) de contact, chaque tampon de contact s'étendant jusqu'au bec en saillie correspondant, de sorte que les becs (12a, 22a, 32a, 42a) en saillie des plaques (12, 22, 32, 42) d'électrode sont mis en contact par la matière conductrice ;
d) on dépose une couche isolante sur les extrémités supérieures des tampons (14, 24, 34, 44) ;
e) on ménage par attaque un sillon (11) disposé sur la surface (8) principale du corps semi-conducteur en passant à travers l'ensemble des couches de matière d'électrode et de matière (16) isolante ;
f) on attaque de manière isotrope la matière (16) isolante entre les couches de matière d'électrode, de façon à ce que les tampons (14, 24, 34, 44) restent entourés de la couche (16) isolante et de manière à ce que les couches en matière d'électrode fassent saillie dans les sillons sous la forme de plaques (12, 22, 32, 42) d'électrode ;
g) on dépose de manière conforme une couche (52) de diélectrique sur les plaques (12, 22, 32, 42) d'électrode ;
h) on remplit le sillon d'au moins une matière conductrice de l'électricité pour former une autre électrode (50) pour les condensateurs de mémoire.

2. Procédé suivant la revendication 1, **caractérisé en ce que** l'on utilise comme couche (52) de diélectrique une matière ayant un ε ou une matière ferroélectrique et **en ce que** les plaques (12, 22, 32, 42) d'électrode ont, au moins du côté tourné vers leur couche (52) de diélectrique, un métal précieux ou des oxydes ou sont entièrement en ces matières.

3. Procédé suivant la revendication 2, **caractérisé en ce que** pour former la deuxième électrode (50), on dépose d'abord, sous la forme d'une mince couche et de manière conforme, l'une des matières mentionnées sur la couche (52) de diélectrique et on remplit un sillon restant d'une autre matière conductrice de l'électricité.
